Europäisches Patentamt

European Patent Office

Office européen des brevets

(11) Veröffentlichungsnummer: **0 497 148 A1**

## EUROPÄISCHE PATENTANMELDUNG

(21) Anmeldenummer: **92100627.6**

(22) Anmeldetag: **16.01.92**

(51) Int. Cl.5: **C30B 15/06**

(30) Priorität: **29.01.91 DE 4102484**

(43) Veröffentlichungstag der Anmeldung:
**05.08.92 Patentblatt 92/32**

(84) Benannte Vertragsstaaten:
**DE FR IT**

(71) Anmelder: **BAYER AG**

**W-5090 Leverkusen 1 Bayerwerk(DE)**

(72) Erfinder: **Knauth, Philippe, Dr., Faculte des Sciences de St.**
**Jerome, case 511, Av Escadrille Normandie-Niemen**
**F-13397 Marseille Cedex 13(FR)**
Erfinder: **Schwirtlich, Ingo, Dr.**
**Hausweberstrasse 26**
**W-4150 Krefeld(DE)**

(54) Verfahren zur Herstellung von Metallscheiben sowie die Verwendung von Siliciumscheiben.

(57) Die vorliegende Erfindung betrifft ein Verfahren zur Herstellung von Metallscheiben definierter Abmessung nach dem Folienziehverfahren, wobei eine Metallschmelze auf einer Unterlage kristallisiert wird sowie die Verwendung entsprechend hergestellter Siliciumscheiben.

FIG.1

Die vorliegende Erfindung betrifft ein Verfahren zur Herstellung von Metallscheiben definierter Abmessung nach dem Folienziehverfahren, wobei eine Metallschmelze auf einer Unterlage kristallisiert wird sowie die Verwendung entsprechend hergestellter Siliciumscheiben.

Die Photovoltaik wird zur elektrischen Energiegewinnung in großtechnischem Maßstab nur dann aus wirtschaftlichen Gesichtspunkten konkurrenzfähig werden, wenn es gelingt, die Herstellkosten für Solarzellen noch erheblich weiter zu senken.

Solarzellen aus multikristallinem Silicium haben in den vergangenen Jahren einen bedeutenden Anteil der photovoltaischen Energiegewinnung sichergestellt, wobei sie neben den inhärenten Vorteilen von Silicium, wie seine Umweltfreundlichkeit, weite Verbreitung des Ausgangsmaterials Siliciumdioxid und relativ hoher und über lange Zeit stabiler Wirkungsgrad, den Vorteil einer bereits weitgehend ausgereiften Technologie zur Herstellung der Solarzellen aufweisen. Allerdings steht einer weiteren Verbreitung von Solarzellen auf der Basis multikristallinen Siliciums die weiterhin unbefriedigende Kostensituation im Wege. Der Ansatzpunkt für eine signifikante Kostensenkung ist die Herstellung der multikristallinen Siliciumscheiben (Wafer).

Stand der Technik ist das Schmelzen, Gießen und gerichtete Erstarren von Silicium zu multikristallinen Blöcken mit kolumnarem Kristallwachstum. Der anschließende mechanische Zerteilungsschritt führt zu multikristallinen Siliciumscheiben, aus denen Solarzellen mit hohen Wirkungsgraden hergestellt werden können.

Apparaturen zur Herstellung multikristalliner Siliciumblöcke sind z.B. aus der US-S 4 175 610, US-A 4 256 681 und EP-A 0 021 385 bekannt. Zum Zerteilen der Blöcke werden gewöhnlich mechanische Sägen verwendet, die hauptsächlich nach dem Innenlochsägeprinzip arbeiten (EP-A 0 269 997). Eine Vorrichtung zum Zerteilen von Halbleitermaterial mittels einer aus einem Metallband bestehenden Säge wird in DP-A 3 305 696 beschrieben. Der Verschnitt bei jedem Sägeschritt beträgt mindestens 180 $\mu$m bei Innenlochsägen, auch bei Drahtsägen tritt ein Verschnitt in vergleichbarer Größenordnung auf, da die Schnittbreite bei 120 bis 150 $\mu$m liegt.

Gattersägen aus mehreren parallelen Metallbändern führen ebenfalls zu Schnittbreiten von 120 bis 150 $\mu$m. Bei allen diesen bekannten mechanischen Zerteilungsverfahren wird zwischen einem Viertel und der Hälfte des Halbleitermaterials durch Verschnitt verloren.

Um diesen Verlust zu vermeiden, werden gegenwärtig schnelle Folienziehverfahren entwickelt, die es erlauben, unmittelbar Siliciumfolien geeigneter Dicke zu erhalten, ohne den material- und kostenintensiven Umweg über den Blockguß und die Blockzerteilung zu gehen. Schnelle Folienziehverfahren mit einer hohen Flachenerzeugungsrate, welche potentiell geeignet sind die geschilderten Probleme zu umgehen, sind aus den EP-A 0 170 119, EP-A 0 072 565 und EP-A 0 165 449 bekannt.

Beim Verfahren zum Herstellen bandförmiger Siliciumkristalle nach der EP-A 0 170 119 wird ein gegenüber der Siliciumschmelze resistenter Trägerkörper in horizontaler Richtung tangierend über die in einer Wanne befindliche Schmelze gezogen und mit Silicium beschichtet. Beim Verfahren nach der EP-A 0 072 565 wird schmelzflüssiges Halbleitermaterial über eine schlitzförmige Öffnung auf einen steil nach oben transportierten Substratkörper aufgebracht. Beim Verfahren nach der EP-A 0 165 449 wird der schmelzflüssige Halbleiter mit Hilfe eines Formkörpers auf eine Unterlage gebracht, wobei die Unterlage relativ zum Formkörper bewegt und ein Temperaturgradient zwischen Formkörper und Unterlage so eingestellt wird, daß in diesem Bereich die Kristallisation einsetzt.

Die geometrische Form der erhaltenen Metallfolien ist von den experimentellen Gegebenheiten beim Ziehprozeß abhängig. Beim Verfahren nach der EP-A 0 170 119 wird die Geometrie der Metallfolien durch den Trägerkörper bestimmt, der in sie inkorporiert wird, d.h., es werden im allgemeinen Metallbänder erhalten. Beim Prozeß nach der EP-A 0 072565 wird die Form der Metallfolien durch die Geometrie der Substratkörper bestimmt. Zum Beispiel werden durch Beschichtung von zehn 50 mm x 50 mm großen Substratplatten Siliciumfolien von 500 mm Länge und 50 mm Breite erhalten. Beim Verfahren nach der EP-A 0 165 449 bestimmen die Abmessungen des Formkörpers die Größe der Grenzfläche zwischen der flüssigen und bereits erstarrten Phase und die seitlichen Abmessungen der Metallfolien.

Um das Kostenreduktionspotential einer Fertigung von Solarzellen im großen Maßstab voll nutzen zu können, ist es notwendig, die Siliciumscheiben aus dem schnellen Folienziehverfahren in den automatisierten Verfahrensablauf zur Herstellung von Solarzellen einführen zu können. Dazu müssen die Siliciumscheiben gewissen Anforderungen genügen, die im allgemeinen im Rahmen einer Spezifikation definiert sind. Von besonderer Bedeutung ist die Maßgenauigkeit der geometrischen Abmessung. Liegt sie außerhalb der Spezifikation, ist mit Störungen des automatisierten Verfahrensablauf zu rechnen. Außerdem ist die Herstellung von Siliciumscheiben verschiedener Geometrie wünschenswert, denn sie erlaubt eine optimale Anpassung von Solarzellen an räumlich Gegebenheiten, z.B, zur vollständigen Abdeckung großer Flächen oder zur Realisierung optisch ansprechender Komponenten. Es ist daher von Bedeutung, schnelle Folienziehverfahren dahingehend zu optimieren, daß Metallkörper unterschiedlicher Flächenform mit streng definierten und reproduzierbaren Abmessungen erhalten werden können.

Die Bildung von Metallkörpern vorgegebener Flächenform kann gemäß der DE-A 3 210 409, dadurch erreicht werden, daß in Ergänzung zur EP 0 170 119 ein Trägerkörper verwendet wird, der unbeschichtete Maschenzeilen enthält. Diese Zeilen sind so angeordnet, daß ein von ihnen umrandetes Feld des Trägerkörpers der Größe einer Solarzelle (z.B. 10 cm x 10 cm) entspricht. Die unbeschichteten Maschenstege werden anschließend mit einem scharfen Trennwerkzeug durchgetrennt.

In der DE-A 3 210 403 wird als Alternative vorgeschlagen, einen Trägerkörper zu verwenden, der an den für die Zerteilung vorgesehenen Bereichen Maschenzeilen aufweist, deren Maschen größere Weiten aufweisen. Nachteile dieser Verfahren sind zweifelsohne der hohe Aufwand für die Präparation der modifizierten Trägerkörper und die Notwendigkeit eines separaten mechanischen Durchtrennens der Trägerkörper.

Aufgabe dieser Erfindung ist somit, ein Verfahren zur Herstellung von Metallscheiben definierter Form und Größe zur Verfügung zu stellen, welches die Nachteile der oben beschriebenen Verfahren nicht aufweist.

Überraschenderweise wurde nun gefunden, daß die gestellte Aufgabe dadurch gelöst werden kann, daß bei der Kristallisation von Metallschmelzen nach dem Folienziehverfahren an der Unterlage Materialveränderungen vorgenommen werden, die eine Änderung des Benetzungsverhaltens der Schmelze zur Folge haben.

Gegenstand dieser Erfindung ist somit ein Verfahren zur Herstellung von Metallscheiben definierter Abmessung nach dem Folienziehverfahren, wobei eine Metallschmelze auf einer Unterlage kristallisiert wird, dadurch gekennzeichnet, daß an der Unterlage, an den der Abmessung der Metallscheiben entsprechenden Stellen Materialveränderungen vorgenommen werden, die eine Änderung des Benetzungsverhaltens der Metallschmelze zur Folge haben.

Die Materialveränderungen können bevorzugt durch Einarbeiten von Vertiefungen erzielt werden. Diese Vertiefungen sind insbesondere Nuten mit einer Breite und Tiefe von wenigstens 1 mm.

Die Unterlage besteht aus Materialien, die gegenüber der Metallschmelze resistent sein soll. Besonders bevorzugt besteht die Unterlage aus Graphit, $Si_3N_4$, $SiO_2$, SiC und/oder keramischen Metalloxiden.

Bei genügend großer Oberflächenspannung wird beobachtet, daß der Schmelzefilm beim Beschichten der Unterlage an den Vertiefungen abreißt. Es wird somit ein Metallkörper mit reproduzierbar scharfen Randbegrenzungen erhalten.

Gute Ergebnisse erhält man dabei, beim Einsatz von Metallen, wie z.B. Woodsches Metall, Zinn und Blei, bei denen die Vertiefungen aufgrund der geringen Oberflächenspannung der Schmelze bevorzugt eine Breite und Tiefe von wenigstens 5 mm aufweisen.

Bei Metallen mit höherer Oberflächenspannung können die Breiten und Tiefen entsprechend geringer sein. Bevorzugt wird als Metallschmelze eine Siliciumschmelze eingesetzt. Hier sind Breiten und Tiefen von wenigstens 1 mm erforderlich.

Durch Anwendung des erfindungsgemäßen Verfahrens ist die Weiterverarbeitung der Metallscheiben in automatisierten Prozessen möglich, bei denen das genaue Einhalten vorgegebener Abmessungen erforderlich ist, z.B. bei der Verarbeitung von Siliciumscheiben zu Solarzellen. Das erfindungsgemäße Verfahren ermöglicht zudem die Herstellung von Metallflächen beliebiger Flächenform, falls ein entsprechendes Vertiefungsmuster der Konturen in die Unterlage eingearbeitet wird. Dies eröffnet die Möglichkeit zur vollständigen Abdeckung großer Flächen durch periodisches Aneinanderlegen von Metallflächen, zudem ist die beliebige häufige Wiederverwendung der Unterlage möglich, so daß die Herstellung der Metallflächen äußerst ökonomisch ist.

Die beschriebene Erfindung kann in besonders vorteilhafter Weise in das in EP-A 0 165 449 beanspruchte Verfahren integriert werden. Neben Silicium können andere Metalle und Substanzen mit genügend hoher Oberflächenspannung verwendet werden.

Die erfindungsgemäßen Materialveränderungen können auch durch Einlegen oder Aufbringen geeigneter Subtanzen auf die Unterlage erreicht werden, wodurch ein Abreißen des Schmelzfilms und damit eine Formgebung erzielt wird.

Gegenstand dieser Erfindung ist auch die Verwendung erfindungsgemäß hergestellter Siliciumscheiben als Ausgangspunkt für Solarzellen.

Die nachfolgenden Beispiele sollen das erfindungsgemäße Verfahren verdeutlichen, ohne eine Einschränkung des Erfindungsgedankens darzustellen.

Beispiel 1

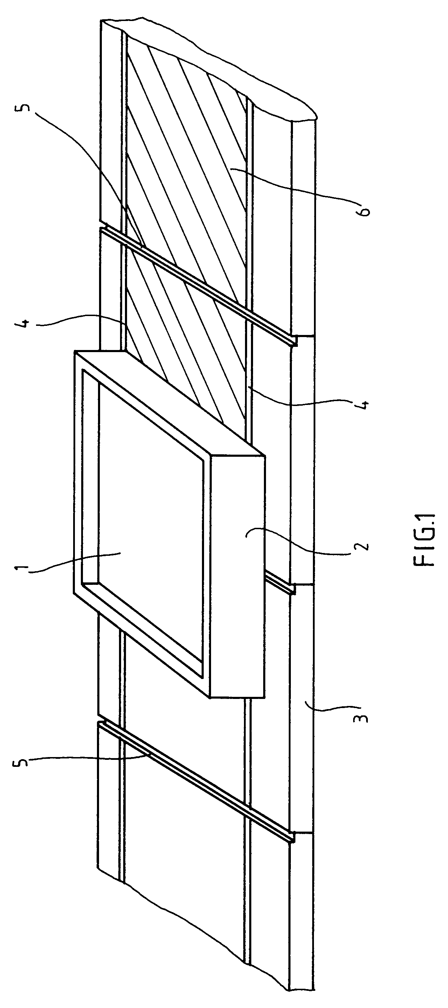

In einer Apparatur (Fig. 1) gemäß EP-A 0 165 449 wurde schmelzflüssiges Silicium (1) dessen Temperatur 1500°C betrug, in einen Formkörper (2) aus Graphit von 100 mm x 100 mm Grundfläche eingefüllt. Der Formkörper lag auf einer kälteren Substratplatte (3) aus Graphit mit einer Temperatur von 1250°C, die mit einer Geschwindigkeit von 6,5 m/min unter dem Formkörper hindurchgezogen wurde. In die Substratplatte waren seitlich im Abstand von 100 mm Nute (4) von je 2 mm Breite und Tiefe eingearbeitet. Es wurde ein Siliciumband von ca. 0,5 mm Dicke erhalten, dessen Breite exakt 100 mm betrug.

## Beispiel 2

Es wurde entsprechend Beispiel 1 verfahren, wobei statt einer durchgehenden, getrennte Substratplatten einer Länge von je 102 mm eingesetzt wurden. In jede Substratplatte waren seitlich Nuten im Abstand von 100 mm eingearbeitet, wie in Fig. 1 gezeigt. Zusätzlich war auf einer Seite jeder Substratplatte ein Nut (5) von 2 mm Breite und Tiefe. Der Abstand zwischen zwei aufeinanderfolgenden Nuten betrug auf diese Weise ebenfalls 100 mm, wenn alle Substratplatten aneinander "auf Stoß" aufgereiht waren (vgl. Fig. 1). Es wurden auf diesem Wege getrennte Siliciumscheiben (6) von exkat je 100 mm Breite und Länge erhalten.

## Beispiel 3

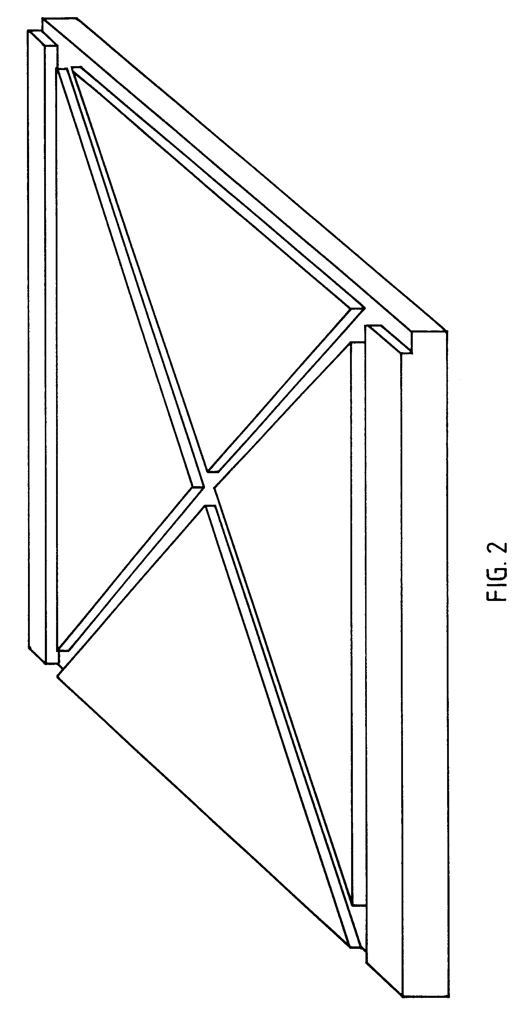

In Substratplatten nach Fig. 1 wurden zusätzlich zu den bereits beschriebenen Vertiefungen, zwei diagonale Nuten eingearbeitet (Fig. 2). Außerdem wurde mit schmelzflüssigem Wood'schem Metall und mit schmelzflüssigem Silicium beschichtet. Es wurden 4 Dreiecke aus Wood'schem Metall und Silicium erhalten, Analog lassen sich mit anderen Vertiefungsmustern Scheiben unterschiedlicher Flächenform aus Silicium, Wood'schem Metall oder anderen Materialien genügend hoher Oberflächenspannung auf einfachem Wege herstellen.

## Patentansprüche

1. Verfahren zur Herstellung von Metallscheiben definierter Abmessung nach dem Folienziehverfahren, wobei eine Metallschmelze auf einer Unterlage kristallisiert wird, dadurch gekennzeichnet, daß an der Unterlage, an den der Abmessung der Metallscheiben entsprechenden Stellen, Materialveränderungen vorgenommen werden, die eine Änderung des Benetzungsverhaltens der Metallschmelze zur Folge haben.

2. Verfahren gemäß Anspruch 1, dadurch gekennzeichnet, daß die Materialveränderungen durch Einarbeiten von Vertiefungen erzielt werden.

3. Verfahren gemäß Anspruch 2, dadurch gekennzeichnet, daß die Vertiefungen aus Nuten mit einer Breite und Tiefe von mindestens 1 mm bestehen.

4. Verfahren gemäß einem oder mehreren der Ansprüche 1 bis 3, dadurch gekennzeichnet, daß die Unterlage aus Graphit, $Si_3N_4$, $SiO_2$, SiC und/oder keramischen Metalloxiden besteht.

5. Verfahren gemäß einem oder mehreren der Ansprüche 1 bis 4, dadurch gekennzeichnet, daß die Metallschmelze eine Siliciumschmelze ist.

6. Verwendung der gemäß Anspruch 5 hergestellten Siliciumscheiben als Ausgangsmaterial für Solarzellen.

FIG.1

FIG. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,Y | EP-A-0 165 449 (BAYER AG)<br>* Ansprüche 1,8,10; Abbildungen 1,2 *<br>--- | 1,2 | C30B15/06 |
| Y | PATENT ABSTRACTS OF JAPAN<br>vol. 12, no. 67 (M-673)2. März 1988<br>& JP-A-62 212 042 ( KAWASAKI STEEL CORP. ) 18.<br>September 1987<br>* Zusammenfassung *<br>--- | 1,2 | |
| A | EP-A-0 381 051 (HELIOTRONIC MBH)<br>* Ansprüche 1,11 *<br>--- | 1-3,6 | |
| A | JOURNAL OF CRYSTAL GROWTH.<br>Bd. 50, Nr. 1, September 1980, AMSTERDAM NL<br>Seiten 260 - 278;<br>J.D. ZOOK ET AL: 'SUPPORTED GROWTH OF SHEET<br>SILICON FROM THE MELT'<br>*ZUSAMMENFASSUNG*<br>* Abbildungen 3,7; Tabelle 1 *<br>--- | 1 | |
| A | EP-A-0 016 905 (ALLIED CHEMICAL CORPORATION)<br>* Anspruch 1; Abbildungen 3,4 *<br>--- | 1 | RECHERCHIERTE SACHGEBIETE (Int. Cl.5) |
| A | JOURNAL OF CRYSTAL GROWTH.<br>Bd. 104, Nr. 1, 1. Juli 1990, AMSTERDAM NL<br>Seiten 108 - 112;<br>H. LANGE ET AL: 'RIBBON GROWTH ON SUBSTRATES<br>(RGS) - A NEW APPROACH TO HIGH SPEED GROWTH OF<br>SILICON RIBBONS FOR PHOTOVOLTAICS'<br><br>----- | 1 | C30B<br>B22D |

Der vorliegende Recherchenbericht wurde für alle Patentansprüche erstellt

| Recherchenort | Abschlußdatum der Recherche | Prüfer |
|---|---|---|
| DEN HAAG | 08 APRIL 1992 | GREGG N.R. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
...............................................................
& : Mitglied der gleichen Patentfamilie, übereinstimmendes
    Dokument